Europäisches Patentamt

European Patent Office

Office européen des brevets

(19)

(11) Publication number: **0 239 225 B1**

(12) **EUROPEAN PATENT SPECIFICATION**

(45) Date of publication of patent specification: **10.07.91** (51) Int. Cl.5: **G11C 11/409**

(21) Application number: **87301357.7**

(22) Date of filing: **17.02.87**

(54) Semiconductor memory device.

(30) Priority: **26.02.86 JP 41281/86**

(43) Date of publication of application:
**30.09.87 Bulletin 87/40**

(45) Publication of the grant of the patent:
**10.07.91 Bulletin 91/28**

(84) Designated Contracting States:
**DE FR GB**

(56) References cited:
**DE-B- 2 647 394**

**IEEE JOURNAL OF SOLID-STATE CIRCUITS,
vol. SC-19, no. 4, August 1984, pages
451-454, IEEE, New York, US; N. CHAU-CHU
LU et al.: "Half-VDD Bit-line sensing scheme
in CMOS DRAM's"**

**IBM TECHNICAL DISCLOSURE BULLETIN, vol.
22, no. 1, June 1979, pages 214-216, New
York, US; G.W. LEEHAN: "Charge shuttle
clock driver"**

**IEEE ISSCC 28. Febr. 85, New York, US, pp.
252-253, Saito et al.: "A 1 Mb CMOS DRAM
with Fast Page and Static Column Modes"**

(73) Proprietor: **MITSUBISHI DENKI KABUSHIKI
KAISHA
2-3, Marunouchi 2-chome Chiyoda-ku
Tokyo 100(JP)**

(72) Inventor: **Miyamoto, Hiroshi
Mitsubishi Denki K.K. LSI Kenkyusho
1 Mizuhara 4-chome Itami-shi Hyogo-ken(JP)**
Inventor: **Yamada, Michihiro
Mitsubishi Denki K.K. LSI Kenkyusho
1 Mizuhara 4-chome Itami-shi Hyogo-ken(JP)**

(74) Representative: **Beresford, Keith Denis Lewis
et al
BERESFORD & Co. 2-5 Warwick Court High
Holborn
London WC1R 5DJ(GB)**

## Description

The present invention relates to a dynamic random access memory (dynamic RAM). In particular it concerns a memory having a folded bit-line structure and formed by a CMOS process.

EP-A-0239208, falling under Article 54(3) EPC, discloses a dynamic RAM having a folded bit-line structure and in which CMOS amplifier and restore circuit parts are separated and located each side of each memory block.

A dynamic RAM having a folded bit-line structure is known and is described for example in United States Patent No 4, 122, 546 (Von Basse et al). In one arrangement, shown in figure 3 of this reference, the memory cells are connected to a pair of bit-lines and the latter arranged across a weighting network, specifically an MOS flip-flop, located at one end of the pair of bit-lines and on one side only of all the memory cells. This replaces an earlier type of structure in which the memory cells are connected to lines extending each side of the weighting network. Because of the line pairing and localised arrangement of memory cells, more consistent electrical properties and thus improved behaviour are said to be attainable. A similar arrangement is also described in the article entitled "A 1 Mb CMOS DRAM with Fast Page and Static Column Modes" by Saito, S. et al in IEEE International Solid State Circuits Conference, 28 Feb 1985, New York, USA, pages 252 and 253. In this arrangement a CMOS amplifier (having a sense amplifier portion and a restore circuit portion, respectively, formed of complementary conductivity type transistors) is used in place of the flip-flop weighting network.

A dynamic RAM generally employs a memory cell comprising a single transistor and a single capacitor. In this case, the smaller the ratio of capacitance of a bit-line to capacitance of a capacitor in a memory cell is, the larger amount of change in potential on a bit-line at the time of read-out is, and the larger input potential difference for a sense amplifier is, so that read-out operation is ensured. However, as the density of a memory is increased significantly and integration increased, the size of each memory cell is made smaller, and consequently the capacitance of each capacitor is reduced. On the other hand, since the number of memory cells connected to a single bit-line is also increased, each bit line becomes longer, and thus the capacitance of each bit-line tends to be increased. As a result, the ratio of the capacitance of each bit-line to the capacitance of each memory capacitor is increased, so that eventually read-out operation can become unreliable.

To solve this problem, each bit-line is divided up and the memory cells are divided into a corresponding plurality of blocks so that the ratio of the capacitance of a memory capacitor to the capacitance of each bit line is then reduced.

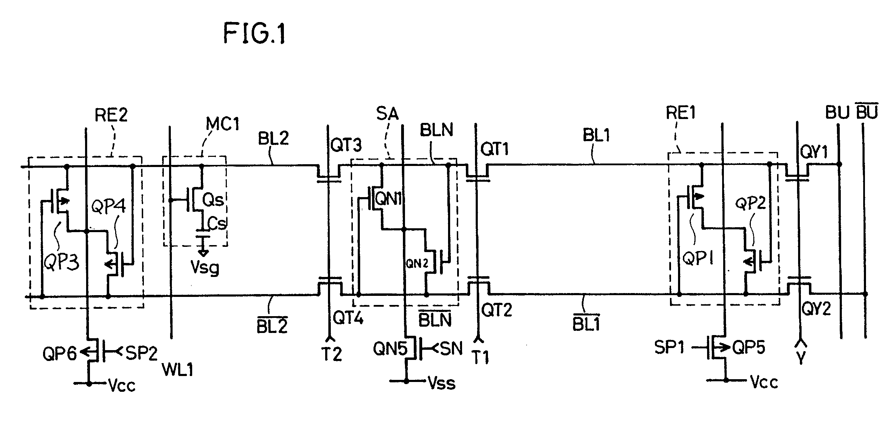

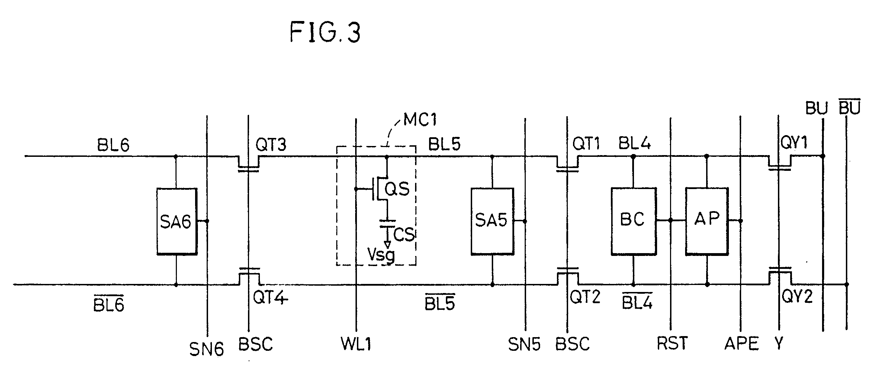

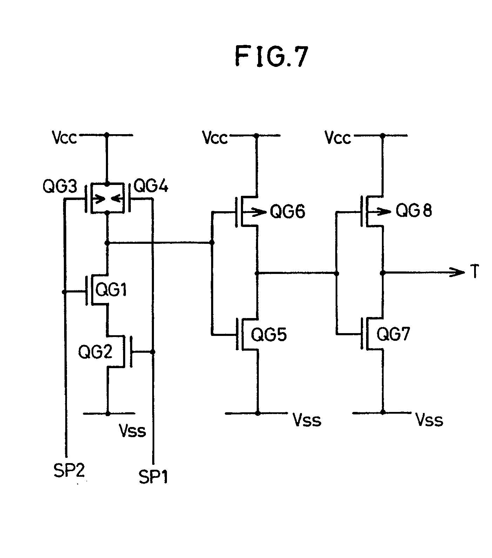

This is shown in the arrangement of figure 7 of, and is discussed in, the reference US 4, 122, 546 just acknowledged. In the more recent development of dynamic RAM the functions of pull-up and pull-down amplification have been performed respectively by spaced sense amplifiers and restore circuits of complementary transistor type. In each of the two examples shown in figures 1 and 3 either a sense amplifier or a restore circuit is provided adjacent to each memory cell block and the other is provided either as a shared resource, one between two (figure 1) or as a common resource, at one end of the paired bit-line (figure 3). As will be outlined below, each of these arrangements proves to be disadvantageous.

Fig. 1 is a diagram showing a structure of a part of a conventional dynamic RAM, which is disclosed, for example, in an article of Digest of Technical Papers, ISSCC '84, pp. 278-279. In Fig. 1, a so-called shared sense amplifier structure is shown wherein a bit line is divided into two parts and a sense amplifier is inserted and shared between each pair of divided bit lines. In addition, in the above described document, the transistor in the memory cell is a p channel MOS transistor, the sense amplifier comprises only p channel MOS transistors, and the restore circuit comprises only n channel MOS transistors. For simplicity, the conductivity type of these transistors is inverted and the structure thereof is slightly simplified in Fig. 1.

In Fig. 1, the pair of bit lines of a folded bit line structure comprises a one bit line divided into three divided bit lines BL1, BLN and BL2, and another and complementary bit line divided into three divided bit lines $\overline{BL1}$, $\overline{BLN}$ and $\overline{BL2}$. A sense amplifier SA for detecting potential difference on the pair of divided bit lines and amplifying the potential difference is connected to the intermediate pair of divided bit lines BLN and $\overline{BLN}$. The pair of divided bit lines BL1 and $\overline{BL1}$ are connected to a first restore circuit RE1 for boosting the potential on the divided bit line at higher potential, while the pair of divided bit lines BL2 and $\overline{BL2}$ are connected to a second restore circuit RE2.

The sense amplifier SA comprises an n channel MOS transistor QN1 having a drain connected to the divided bit line BLN, a gate connected to the divided bit line $\overline{BLN}$ and a source connected to a sense amplifier driver transistor QN5, and an n channel MOS transistor QN2 having a gate connected to the divided bit line BLN, a drain connected to the divided bit line $\overline{BLN}$ and a source connected to one conduction terminal of a sense amplifier driver transistor QN5. The sense amplifier driver transistor QN5 has a gate receiving an activating signal SN and its other conduction terminal connected to a ground potential $V_{SS}$. The sense amplifier SA is activated when the sense amplifier driver transistor QN5 is turned on, and accordingly the potential on the bit line at lower potential is brought close to the ground potential $V_{SS}$.

The first restore circuit RE1 connected to the pair of divided bit lines BL1 and $\overline{BL1}$ comprises a p channel MOS transistor QP1 having a drain connected to the divided bit line BL1, a gate connected to the complementary divided bit line $\overline{BL1}$ and a source connected to one conduction terminal of a restore circuit driver transistor QP5, and a p channel MOS transistor QP2 having a drain connected to the complementary divided bit line $\overline{BL1}$, a gate connected to the divided bit line BL1 and a source connected to one conduction terminal of the restore circuit driver transistor QP5. The restore circuit driver transistor QP5 comprises a p channel MOS transistor having other conduction terminal connected to a power supply potential $V_{CC}$ and a gate receiving a restore circuit activating signal SP1. The first restore circuit RE1 is responsive to an on-state of the restore circuit driver transistor QP5 for boosting the potential on the divided bit line at a higher potential in the pair of divided bit lines BL1 and $\overline{BL1}$ to the power supply potential $V_{CC}$.

The second restore circuit RE2 connected to the pair of divided bit lines BL2 and $\overline{BL2}$ comprises a p channel MOS transistor QP3 having a drain connected to the divided bit line BL2, a gate connected to the complementary divided bit line $\overline{BL2}$ and a source connected to one conduction terminal of a restore circuit driver transistor QP6, and a p channel MOS transistor QP4 having a drain connected to the complementary divided bit line $\overline{BL2}$, a gate connected to the divided bit line BL2 and a source connected to one conduction terminal of the restore circuit driver transistor QP6. The restore circuit driver transistor QP6 comprises a p channel MOS transistor having its other conduction terminal connected to the power supply potential $V_{CC}$ and a gate receiving a second restore circuit activating signal SP2. The second restore circuit RE2 boosts the potential on the divided bit line at a higher potential in the pair of divided bit lines BL2 and $\overline{BL2}$ to the power supply potential $V_{CC}$.

The divided bit lines BL1 and BLN are connected to each other through a transfer gate transistor QT1, while the complementary divided bit lines $\overline{BL1}$ and $\overline{BLN}$ are connected to each other through a transfer gate transistor QT2. The transfer gate transistors QT1 and QT2 are turned on and off in response to a transfer signal T1 received at the gate thereof.

The divided bit lines BLN and BL2 are connected to each other through a transfer gate transistor QT3, while the complementary divided bit lines $\overline{BLN}$ and $\overline{BL2}$ are connected to each other through a transfer gate transistor QT4. The transfer gate transistors QT3 and QT4 are turned on and off in response to a second transfer signal T2. The divided bit line BL1 is connected to a data bus line BU through a column gate transistor QY1, while the complementary divided bit line $\overline{BL1}$ is connected to a complementary data bus line $\overline{BU}$ through a column gate transistor QY2. The column gate transistors QY1 and QY2 are turned on and off in response to a column selecting signal Y at the gates thereof.

Although a plurality of memory cells are connected to each of the divided bit lines, only one of these, memory cell MC1, which is connected to the divided bit line BL2 is shown. This memory cell MC1 comprises an n channel MOS transistor $Q_S$ and a capacitor $C_S$. The transistor $Q_S$ has one conduction terminal connected to the bit line BL2, a gate comprising a part of a word line WL1 and another conduction terminal connected to one electrode of the capacitor $C_S$. The capacitor $C_S$ has its connected to a memory cell plate potential $V_{SG}$. The capacitor $C_S$ stores information in the form of charges, and the transistor $Q_S$ is turned on in response to the potential on the word line WL1 to electrically connect the capacitor $C_S$ to the bit line BL2.

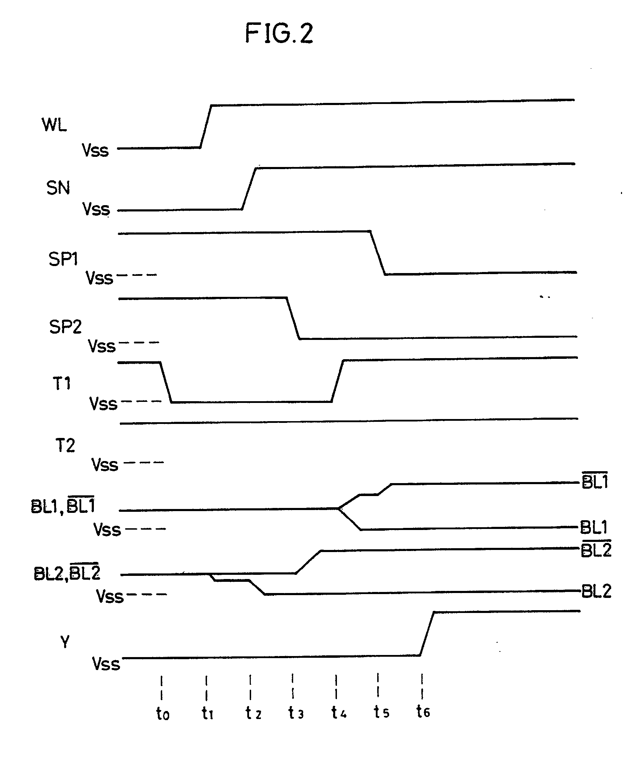

Fig. 2 is a waveform diagram to show the operation of the circuit shown in Fig. 1. In particular the waveforms illustrate operation when information "O" is stored in the memory cell MC1 of the circuit shown in Fig. 1, that is, when the capacitor $C_S$ in the memory cell MC1 is not charged.

Referring now to Figs. 1 and 2, circuit operation will be described.

At time t0, the transfer signal T1 becomes an "L" level. Accordingly, the transfer gate transistors QT1 and QT2 are turned off, so that the divided bit lines BLN and BL1 are electrically isolated, and also the complementary divided bit lines $\overline{BLN}$ and $\overline{BL1}$ are electrically isolated. Before time t0, each of the divided bit lines BL1, $\overline{BL1}$, BL2, $\overline{BL2}$, BLN and $\overline{BLN}$ is precharged at an intermediate potential level $(V_{CC}-V_{SS})/2$.

At time t1, the word WL1 is selected by signals from an address decoder (not shown) and the potential on the word line WL1 becomes an "H" level. Accordingly, the transistor $Q_S$ in the memory cell MC1 is turned on, so that information "O" stored in the capacitor $C_S$ is read out onto the divided bit line BL2. As a result, the potential on the divided bit line BL2 is lowered, so that a potential difference is developed between the divided bit line BL2 and the complementary divided bit line $\overline{BL2}$.

At time t2, a first sense amplifier activating signal SN becomes an "H" level. Accordingly, the sense amplifier SA is activated. As a result, the potential difference is increased between the pair of divided bit lines BL2 and $\overline{BL2}$. More specifically, the sense amplifier driver transistor QN5 is rendered conductive in response to a first sense amplifier activating signal SN, so that sources of the transistors QN1 and QN2 in the sense amplifier SA are connected to the ground potential $V_{SS}$. Since the potential on the divided bit line BLN is lower than that on the complementary divided bit line $\overline{BLN}$ (the transfer gates QT3 and QT4 are rendered conductive because the second transfer signal T2 is at an "H" level), the divided bit line BLN, and thus, the divided bit line BL2, are discharged through the transfer gate QT3 and the transistor QN1 in the sense amplifier SA, so that the potential thereon becomes near the ground potential $V_{SS}$. On the other hand, the potential on the complementary divided bit lines $\overline{BL2}$ and $\overline{BLN}$ is held near the intermediate potential $(1/2).(V_{CC}-V_{SS})$ because the transistor QN2 is almost turned off.

At time t3, the second restore activating signal SP2 becomes an "L" level. Accordingly, the second restore circuit RE2 is activated, so that the potential on the complementary divided bit line $\overline{BL2}$ is pulled up near the power supply potential $V_{CC}$. As a result, the potential difference is increased between the divided bit line BL2 and the complementary divided bit line $\overline{BL2}$. The operation of the restore circuit RE2 is identical to that of the sense amplifier SA with polarity thereof inverted. More specifically, the transistor QP4 is rendered conductive in response to the potential near the ground potential on the divided bit line BL2, and the complementary divided bit line $\overline{BL2}$ is charged, so that the potential thereon becomes near the power supply potential $V_{CC}$. As a result, potential difference is further increased between the pair of divided bit lines BL2 and $\overline{BL2}$.

At time t4, the first transfer signal T1 becomes again an "H" level. Accordingly, the transfer gate transistors QT1 and QT2 are rendered conductive, so that the divided bit lines BLN and BL1 as well as the complementary divided bit lines $\overline{BLN}$ and $\overline{BL1}$ are connected to each other, respectively. Therefore, the potentials on the divided bit line BLN and the complementary divided bit line $\overline{BLN}$ are transferred to the divided bit line BL1 and the complementary divided bit line $\overline{BL1}$, respectively. As a result, the divided bit line BLN is discharged through the transfer gate transistor QT1 and the sense amplifier SA, so that the potential thereon becomes near the ground potential $V_{SS}$. On the other hand, the potential on the complementary divided bit line $\overline{BL1}$ is pulled up through the transfer gate transistors QT2 and QT4 and the restore circuit RE2.

At time t5, the first restore circuit activating signal SP1 becomes an "L" level. Accordingly, the first restore circuit RE1 is activated, so that the potential on the complementary divided bit line $\overline{BL1}$ is pulled up near to the power supply potential $V_{CC}$.

At time t6, a column selecting signal Y becomes an "H" level in response to an output of a column decoder circuit (not shown). Accordingly, the complementary divided bit line $\overline{BL1}$ and the divided bit line BL1 are connected to a complementary data bus line $\overline{BU}$ and a data bus line BU, respectively. Then the potentials on the divided bit lines BL1 and $\overline{BL1}$ are transferred to the data bus lines BU and $\overline{BU}$, so that the information "0" stored in the memory cell MC1 is read out.

In the foregoing, information stored in the capacitor $C_S$ in the memory cell MC1 is read out onto the divided bit line BL2, so that the potential difference between the pair of divided bit lines BL2 and $\overline{BL2}$ is amplified by the sense amplifier SA. The divided bit line BL2, at a lower potential, is discharged at the sense amplifier SA through a transfer gate transistor QT3, so that the potential thereon becomes near to the ground potential $V_{SS}$. In the dynamic RAM with a folded bit line structure a bit line is generally formed of a low resistance material such as aluminium or refractory metal silicide. As a result, resistance of the bit line can be reduced and hence RC delay due to the bit line can be reduced, so that discharge of charges on the bit line can be accelerated.

However, in the dynamic RAM with a shared sense amplifier structure as described above, a transfer gate transistor is provided between a divided bit line connected to a memory cell and a sense amplifier, so that a bit line cannot be formed of low resistance materials in this transistor portion. In addition, as shown in Fig. 1, since the transfer gate transistor must be provided for each divided bit line and for each pitch between bit lines (i.e. the sum of the bit line width and the spacing between bit lines), the transistor width can be made almost the same as or at most twice the pitch between bit lines. Since the pitch between bit lines is, for example, about 3 $\mu$m in a 1 Mega-bit dynamic RAM, the transistor width of the transfer gate is limited to less than several $\mu$m. As a result, since the minimum value of the transistor length is limited in advance, trans-conductance $g_m$ of the transfer gate transistor is reduced, so that discharge of charges on the divided bit line is delayed when the sense amplifier operates.

Furthermore, since the source and a drain of the transfer gate transistor are formed of a diffusion layer provided in a substrate or a well, noise is transferred to a bit line through the substrate or the well, so that the sense amplifier can operate erroneously due to the noise.

Fig. 3 is a diagram showing part of structure of another conventional dynamic random access memory, which is disclosed in Japanese Laying-Open Gazette No. 101093/1984. In Fig. 3, the bit line is divided into three parts and the circuit comprises only n channel MOS transistors.

A first pair of divided bit lines BL4 and $\overline{BL4}$ are connected to a bit line precharge circuit BC which is activated in response to a reset signal RST for precharging each of divided bit lines BL4, BL5, BL6, $\overline{BL4}$, $\overline{BL5}$ and $\overline{BL6}$ to the intermediate potential $(V_{CC}-V_{SS})/2$. The bit lines BL4 and $\overline{BL4}$ are also connected to an active pull-up circuit AP responsive to a reset signal RST and an active pull-up signal APE for boosting the potential on the divided bit line at a higher potential of the pair of divided bit lines BL4 and $\overline{BL4}$ to the power supply potential $V_{CC}$ level.

Pairs of divided bit lines BL5 and $\overline{BL5}$ and BL6 and $\overline{BL6}$ are provided with memory cells, sense amplifiers SA5 and SA6, respectively. Although many memory cells are connected to the pairs of the divided bit lines BL5 and $\overline{BL5}$ and BL6 and $\overline{BL6}$, only one of these memory cell MC1, which is connected to the divided bit line BL5, is shown in Fig. 3.

The transfer gate transistors QT1 to QT4, which are turned on/off in response to a transfer signal BSC, are provided between the divided bit lines, respectively. The divided bit lines BL4 and $\overline{BL4}$ are connected to the data buses BU and $\overline{BU}$ through transfer gates QY1 and QY2, respectively.

The transfer gate transistors QY1 and QY2 for selecting column are turned on and off in response to the column selecting signal Y from an address decoder circuit (not shown).

Additionally, sense amplifiers SA5 and SA6 are activated in response to sense amplifier activating signals SN5 and SN6.

The memory cell MC1 comprises a transistor $Q_S$ and a capacitor $C_S$. The transistor $Q_S$ has a gate being a part of the word line WL1, one conduction terminal connected to the divided bit line BL5 and another conduction terminal connected to one electrode of the capacitor $C_S$. The capacitor $C_S$ has its other electrode connected to a memory cell plate potential $V_{SG}$. The transistor $Q_S$ in the memoty cell MC1 is rendered conductive in response to the potential applied to the word line WL1, so that the capacitor $C_S$ is electrically connected to the divided bit line BL5.

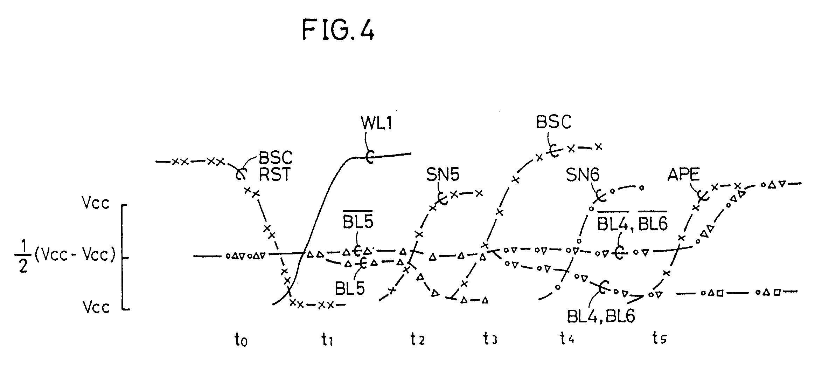

Fig. 4 is a waveform diagram showing operation of the circuit shown in Fig. 3, showing how data is read out when the capacitor $C_S$ in the memory cell MC1 is not charged, that is, when information "0" is stored. Referring now to Figs. 3 and 4, the operation of the circuit shown in Fig. 3 is described.

Before time t0, both the transfer signal BSC and the reset signal RST are at an "H" level, and all the transfer gate transistors QT1 to QT4 are turned on. Thus, the divided bit lines BL4, BL5 and BL6 are connected to each other, and the complementary divided bit lines $\overline{BL4}$, $\overline{BL5}$ and $\overline{BL6}$ are connected to each other. In addition, since the reset signal RST is at an "H" level, the bit line precharge circuit BC is activated in response to the reset signal RST at an "H" level, so that each of the divided bit lines BL4, BL5, BL6, $\overline{BL4}$, $\overline{BL5}$ and $\overline{BL6}$ is precharged at the intermediate potential $(V_{CC}-V_{SS})/2$.

At time t0, both the transfer signal BSC and the reset signal RST become an "L" level, and the transfer gate transistors QT1 to QT4 are turned off, so that each of the divided bit lines is isolated and the bit line precharge circuit BC is inactivated.

At time t1, the potential on the selected word line WL1 becomes an "H" level in response to an output of an address decoder circuit (not shown). Accordingly, the transistor $Q_S$ in the memory cell MC1 is turned on, so that information stored in the capacitor $C_S$ is read out to the bit line BL5. As a result, the potential on the divided bit line BL5 slightly lowers, so that potential difference occurs between the pair of the divided bit lines BL5 and $\overline{BL5}$.

At time t2, the sense amplifier activating signal SN5 becomes an "H" level. Accordingly, the sense amplifier SN5 is activated. As a result, potential difference is increased between the pair of the divided bit lines BL5 and $\overline{BL5}$.

At time t3, the transfer signal BSC becomes an "H" level. Accordingly, all the transfer gate transistors QT1 to QT4 are turned on, so that the potentials on the divided bit line BL5 and the complementary divided bit line $\overline{BL5}$ are transferred to the divided bit lines BL4 and BL6 and the complementary divided bit lines $\overline{BL4}$ and $\overline{BL6}$, respectively.

At time t4, the sense amplifier activating signal SN6 becomes an "H" level. Accordingly, the sense amplifier SA6 is activated. As a result, potential difference is increased between the pair of divided bit lines BL6 and $\overline{BL6}$ and thus, potential difference is further increased between the pairs of divided bit lines BL4 and $\overline{BL4}$ and BL5 and $\overline{BL5}$.

At the time t5, the active pull-up signal APE becomes an "H" level. Accordingly, the active pull-up circuit AP is activated. As a result, the potentials on the complementary divided bit lines $\overline{BL4}$, $\overline{BL5}$ and $\overline{BL6}$ are pulled up near the power supply potential $V_{CC}$.

When the column selecting signal Y from an address decoder circuit (not shown) becomes an "H" level, the gate transistors QY1 and QY2 for selecting column are turned on. Accordingly, the potentials on the divided bit line BL4 and the complementary divided bit line $\overline{BL4}$ are transferred to the data bus line BU and the complementary data bus line $\overline{BU}$, so that information "0" stored in the memory cell MC1 is read out.

As described in the foregoing, in the circuit shown in Fig. 3, a sense amplifier is provided for each pair of divided bit lines, while an active pull-up circuit is provided not for each pair of divided bit lines but for a pair of bit lines which constructs a folded bit line. Therefore, since the potential on an entire bit line must be pulled up by a single active pull-up circuit when the active pull-up circuit operates, the active pull-up circuit having large drive capacity is required. This increases the area occupied by the active pull-up circuit, which prevents high integration of a semiconductor memory.

Additionally, in order to pull up the potential on each of the divided bit lines or each of the complementary divided bit lines to the power supply potential $V_{CC}$ level, the gate potential applied to a transfer gate transistor, that is, an "H" level of the transfer signal BSC must be boosted over the power supply potential $V_{CC}$, in consideration of the threshold voltage of the transfer gate transistor which connects the divided bit lines and the complementary divided bit lines, respectively. However, as integration of a semiconductor memory device increases, a gate oxide film of the MOS transistor formed therein tends to be thinner. For example, the gate oxide film in a 1 Mega-bit dynamic RAM is approximately 200 to 300 Å in thickness. Therefore, if the gate potential is boosted over the power supply potential, dielectric breakdown of the gate oxide film is caused, so that the reliability of the gate oxide film is reduced.

As described in the foregoing, there are some problems in the bit line structure of conventional semiconductor memories. For example, discharge of the (complementary) divided bit lines is delayed when the sense amplifier operates, accordingly fast operation of the memory is not possible. Since the structure is liable to be affected by noise on the bit line, it is difficult to increase the operating margin for the semiconductor memory. In addition, the reliability of the gate oxide film of the transfer gate transistor is reduced.

The present invention is intended as a remedy for the problems aforesaid.

The dynamic RAM of the present invention is a dynamic RAM of the type comprising:
a plurality of paired bit-lines, each each bit-line pair being divided into a plurality of divided bit-line pairs;
a multiplicity of memory cells divided into blocks, each block of memory cells being connected to a respective one of the divided bit line pairs and having each side, respectively, a sense amplifier having one or more MOS transistors of one conductivity type and a restore circuit having one or more MOS transistors of the complementary conductivity type; and
a control circuit for generating restore circuit activating signals for activating sequentially said plurality of restore circuits in a predetermined order commencing with that one of the restore circuits included in that one of the blocks including that one of the memory cells that is being addressed, wherein
each respective sense amplifier and each respective restore circuit are connected to the respective divided bit-line pair; and
each respective divided bit-line pair is divided from the next by one pair of switches, one switch in each bit-line; there being included:
a control means for controlling operation of said one pair of switches, responsive to that pair of restore circuit activating signals applied respectively to the restore circuits in the blocks that are immediately adjacent to said one pair of switches, and operable to render said one pair of switches conductive to follow and in response to whichever one of said pair of restore circuit activating signals is first to go active.

Since in this invention each respective memory cell, sense amplifier and restore circuit are connected to a common divided bit line pair, the initial sensing and restoration operation can be performed prior to transfer operation. Delay otherwise arising due to transfer via the resistive channel of a transfer gate transistor, as in state of the art construction (figure 1), is obviated and accordingly access time is improved. Also, since both a sense amplifier and a restore circuit are provided for each memory cell/divided bit-line section, the problems of common sensing and/or restoration (e.g. figure 3) are also avoided.

In the drawings:
Fig. 1 is a diagram showing the structure of a conventional dynamic random access memory having a folded bit line structure;
Fig. 2 is a waveform diagram showing operation of the dynamic random access memory shown in Fig. 1;
Fig. 3 is a diagram showing the structure of another conventional dynamic access memory also having a folded bit line structure;
Fig. 4 is a waveform diagram of signals showing operation of the dynamic random access memory shown in Fig. 3;
Fig. 5 is a diagram showing the structure of a dynamic random access memory, an embodiment of the present invention;
Fig. 6A is a waveform diagram showing operation of the dynamic random access memory of figure 5 when information "0" is stored in a selected one of the memory cells;

Fig. 6B is a waveform diagram showing operation of the dynamic random access memory of figure 5 when information "1" is stored in the selected memory cell; and

Fig. 7 is a circuit diagram showing a specific structure for the transfer signal generator shown in Fig. 5.

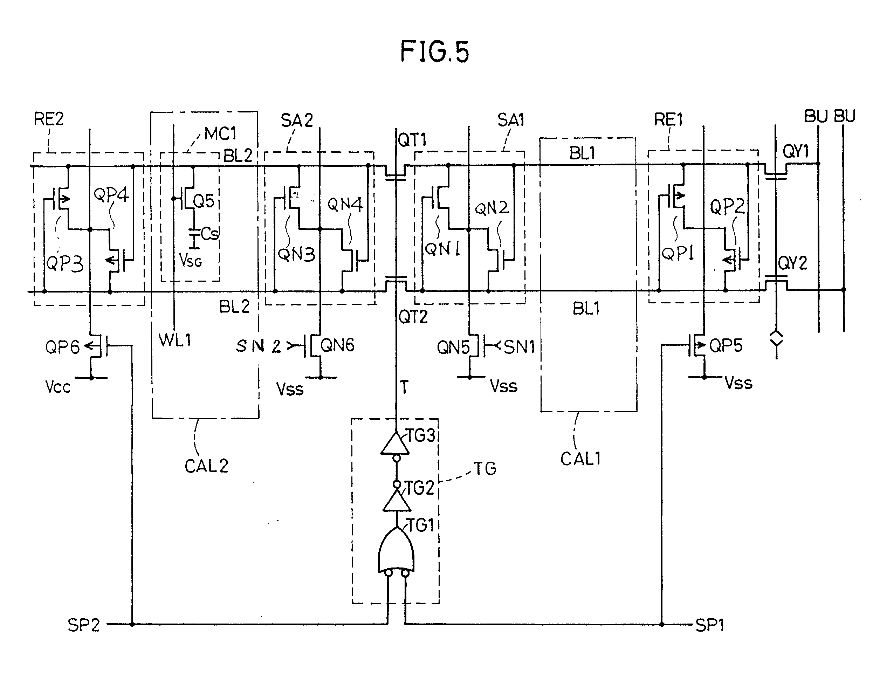

So that this invention shall be better understood, a preferred embodiment thereof will be described below and reference will be made to figures 5 to 7 of the drawings. The description that follows is given by way of example only.

Fig. 5 is a diagram showing a structure of a part of a dynamic random access memory according to an embodiment of the present invention. In Fig. 5, a pair of bit lines with a folded bit line structure are divided into a plurality of blocks, for example, two blocks in Fig. 5.

One pair of divided bit lines BL1 and $\overline{BL1}$ is connected to a sense amplifier SA1 for detecting and amplifying the potential difference developed between the pair of divided bit lines BL1 and $\overline{BL1}$. This pair is also connected to a restore circuit RE1 for detecting and further amplifying the potential difference amplified by the sense amplifier SA1.

The sense amplifier SA1 comprises an n channel MOS transistor QN1 having a drain connected to the bit line BL1, a gate connected to the complementary divided bit line $\overline{BL1}$ and a source connected to one conduction terminal of a sense amplifier driver transistor QN5, and an n channel MOS transistor QN2 having a drain connected to the complementary divided bit line $\overline{BL1}$, a gate connected to the divided bit line BL1 and a source connected to one conduction terminal of the sense amplifier driver transistor QN5. The sense amplifier driver transistor QN5 for activating the sense amplifier SA1 has another conduction terminal connected to a ground potential $V_{SS}$ and has a gate receiving a sense amplifier activating signal SN1.

The restore circuit RE1 comprises a p channel MOS transistor QP1 having a drain connected to the divided bit line BL1, a gate connected to the complementary divided bit line $\overline{BL1}$ and a source connected to one conduction terminal of a restore circuit driver transistor QP5, and a p channel MOS transistor QP2 having a drain connected to the complementary divided bit line $\overline{BL1}$, a gate connected to the divided bit line BL1 and a source connected to one conduction terminal of the restore circuit driver transistor QP5. The restore circuit driver transistor QP5 has another conduction terminal connected to a power supply potential $V_{CC}$ and has a gate receiving a restore circuit activating signal SP1.

The other pair of divided bit lines BL2 and $\overline{BL2}$ are connected to a sense amplifier SA2 for detecting and amplifying potential difference between the pair of divided bit lines BL2 and $\overline{BL2}$, and also connected to a retore circuit RE2 for detecting and further amplifying the potential difference amplified by the sense amplifier SA2.

The sense amplifier SA2 comprises an n channel MOS transistor QN3 having a drain connected to the divided bit line BL2, a gate connected to the complementary divided bit line $\overline{BL2}$ and a source connected to one conduction terminal of a sense amplifier driver transistor QN6, and an n channel MOS transistor QN4 having a gate connected to the complementary divided bit line $\overline{BL2}$, and a gate connected to the divided bit line BL2 and a source connected to one conduction terminal of the sense amplifier driver transistor QN6. The sense amplifier driver transistor QN6 which is an n channel MOS transistor has its other conduction terminal connected to the ground potential $V_{SS}$ and has a gate receiving a sense amplifer activating signal SN2.

The restore circuit RE2 comprises a p channel MOS transistor QP3 having a drain connected to the divided bit line BL2, a gate connected to the complementary divided bit line $\overline{BL2}$, and a source connected to one conduction terminal of the restore circuit driver transistor QP6, and a p channel MOS transistor QP4 having a drain connected to the complementary divided bit line $\overline{BL2}$, a gate connected to the divided bit line BL2 and a source connected to one conduction terminal of the restore circuit driver transistor QP6. The restore circuit driver transistor QP6 which is a p channel MOS transistor has its other conduction terminal connected to the power supply potential $V_{CC}$ and has a gate receiving a restore circuit activating signal SP2.

The divided bit lines BL1 and BL2 are connected to each other through a transfer gate transistor QT1, and the complementary divided bit lines are connected to each other through a transfer gate transistor QT2. A transfer signal T is applied to the gates of the transfer gate transistors QT1 and QT2. The transfer signal T becomes an active level when triggered by one or other of the two restore circuit activating signals SP1 and SP2, the first to change to an active level. A transfer signal generator TG generating the transfer signal T comprises a circuit including an NAND gate TG1 receiving the restore circuit activating signals SP1 and SP2 for performing an NAND operation thereof. In Fig. 5, a structure comprising the NAND gate TG1 and two-stage inverter circuits TG2 and TG3 receiving the output of the NAND gate TG1 for inverting it is shown by way of an example.

The pair of divided bit lines BL1 and $\overline{BL1}$ and data bus lines BU and $\overline{BU}$ for transferring read-out information are connected to each other by column gate transistors QY1 and QY2, respectively. The column gate transistors QY1 and QY2 has gates receiving a column selecting signal Y from an address decoder circuit (not shown).

Memory cells are connected to each pair of divided bit lines, depending on memory capacity, so that divided memory cell arrays CAL1 and CAL2 are formed, respectively. In Fig. 5, only one memory cell MC1 connected to the divided bit line BL2 is shown. The memory cell MC1 comprises an n channel MOS transistor $Q_S$ having a gate being a part of a word line WL1, one conduction terminal connected to the divided bit line BL2 and its other conduction terminal connected to one electrode of a capacitor $C_S$, and the capacitor $C_S$ having one electrode connected to the other conduction terminal of the transistor $Q_S$ and its other electrode connected to a memory cell plate potential $V_{SG}$. The capacitor $C_S$ stores information in the form of charges. The word line WL1 becomes an active level (an "H" level) when it is selected in response to an output from an address decoder circuit (not shown).

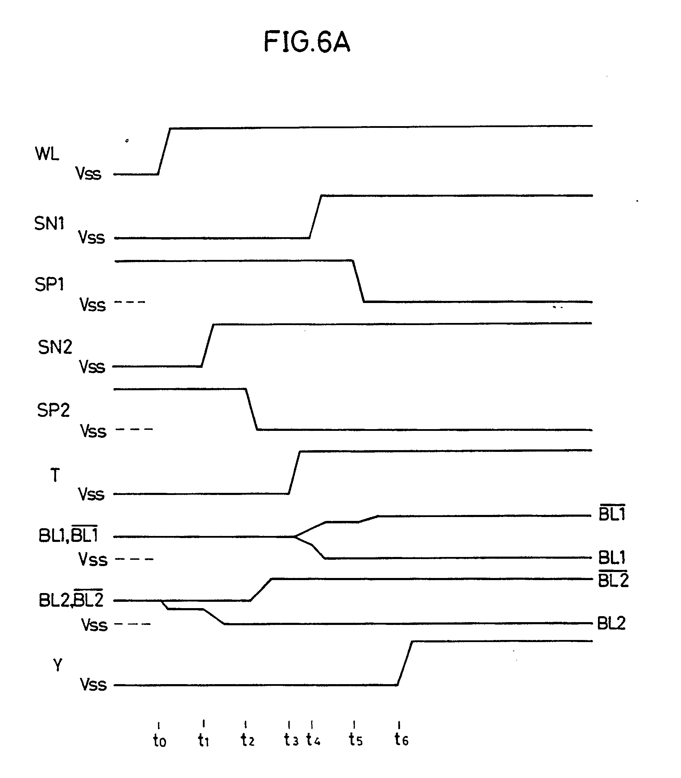

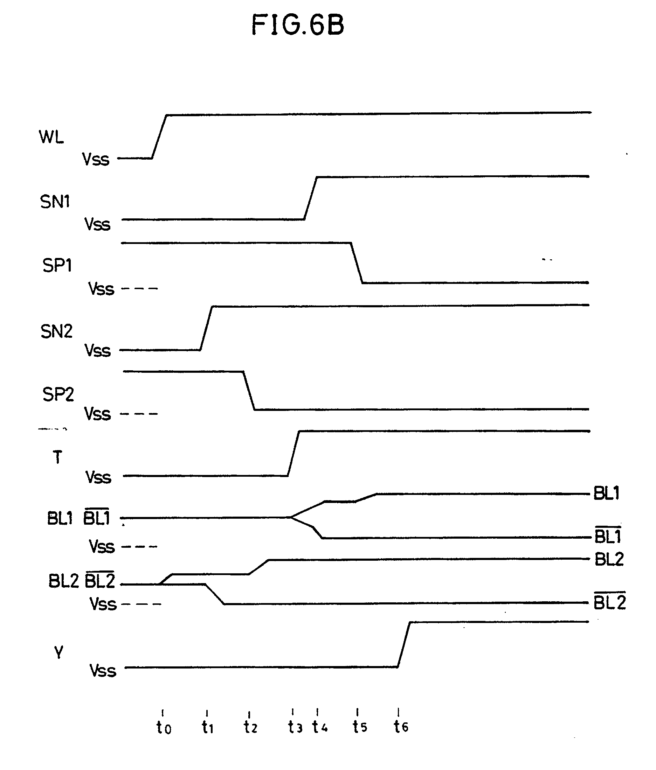

Fig. 6 is a waveform diagram showing operation of the circuit shown in Fig. 5, wherein information "0" is stored in the memory cell MC1. Referring now to Fig. 5 and 6A, operation of the circuit is described.

Before time t0, the divided bit lines BL1, $\overline{BL1}$, BL2 and $\overline{BL2}$ are precharged, so that the potential thereon becomes an intermediate potential ($V_{CC}$-$V_{SS}$)/2.

Details of the precharge circuit components are conventional and have been omitted from the drawing. In addition, the transfer signal T applied to the transfer gate transistors QT1 and QT2 is at an "L" level, so that the divided bit lines are isolated from each other.

At time t0, the word line WL1 is selected by address decoder means (not shown) and the potential on the word line WL1 becomes an "H" level. Thus, the transistor $Q_S$ in the memory cell MC1 is turned on, so that information "0" stored in the capacitor $C_S$ is read out onto the divided bit line BL2. As a result, the potential on the divided bit line BL2 is lowered (the amount of change in potential is determined by the ratio of capacitance of the capacitor $C_S$ and capacitance of the divided bit line BL2), so that a potential difference is developed between the pair of divided bit lines BL2 and $\overline{BL2}$.

At time t1, the sense amplifier activating signal SP2 reaches an "L" level. Accordingly, the sense amplifier SA2 is activated. As a result, the potential difference between the divided bit lines BL2 and $\overline{BL2}$ is increased. More specifically, the potential on the complementary divided bit line $\overline{BL2}$ is held near to an intermediate potential level, while the divided bit line BL2, at a low potential, is discharged through the sense amplifier (through the transistors QN3 and QN6), so that the potential thereon becomes near to the ground potential $V_{SS}$.

At time t2, the restore circuit activating signal SP2 becomes an "L" level. Accordingly, the restore circuit driver transistor QP6 is rendered conductive, so that the restore circuit RE2 is activated. As a result, the potential on the complementary divided bit line $\overline{BL2}$ at an intermediate potential level is pulled up near the power supply potential $V_{CC}$ through the restore circuit RE2, so that potential difference is further increased between the pair of divided bit lines BL2 and $\overline{BL2}$.

At time t3, the transfer signal T generated from the transfer signal generator TG by being triggered by transition of the restore circuit activating signal SP2 to an "L" level becomes an "H" level. Accordingly, the transfer gate transistors QT1 and QT2 are turned on, so that the divided bit lines are connected to each other. Thus, the potentials on the divided bit line BL2 and the complementary divided bit line $\overline{BL2}$ are transferred to the divided bit line BL1 and the complementary divided bit line $\overline{BL1}$, respectively. As a result, the potential on the divided bit line begins to be discharged through the transfer gate transistor QT1 and the sense amplifier SA2, while the potential on the complementary divided bit line $\overline{BL1}$ begins to be pulled up from an intermediate potential level through the transfer gate transistor QT2 and the restore circuit RE2.

At the time t4, the sense amplifier activating signal SN1 becomes an "H" level. Accordingly, the sense amplifier driver transistor QN5 is turned on, so that the sense amplifier SA1 is activated. As a result, the divided bit line BL1 is discharged at fast speed, so that the potential thereon becomes near to the ground potential $V_{SS}$.

At time t5, the restore circuit activating signal SP1 becomes an "L" level. Accordingly, the restore circuit driver transistor QT5 is turned on, so that the restore circuit RE1 is activated. As a result, the potential on the complementary divided bit line $\overline{BL1}$ is pulled up near to the power supply potential $V_{SS}$.

At time t6, the bit line is selected by signals from column address decoder means (not shown) and the column selecting signal Y becomes an "H" level. Accordingly, the column gate transistors QY1 and QY2 are turned on, so that the pair of divided bit lines BL1 and $\overline{BL1}$ are connected to the data bus lines BU and $\overline{BU}$. As a result, the potentials on the pair of divided bit lines BL1 and $\overline{BL1}$ are transferred to the data bus lines BU and $\overline{BU}$, so that information "0" stored in the selected memory cell MC1 is read out.

The operating sequence in the sense amplifiers SA1 and SA2 and the restore circuits RE1 and RE2 is determined depending on the row address by which the memory cell is selected in the memory cell array. Thus, if the memory cell in the memory cell array CAL1 is selected, the sense amplifier SA1 and the restore circuit RE1 are activated. prior to the sense amplifier SA2 and the restore circuit RE2.

Fig. 6B is a waveform diagram showing operation, showing how data is read out when the capacitor $C_S$ in the selected memory cell MC1 is charged, that is, when information "1" is stored. Referring now to Figs. 5 and 6B, operation for reading out information "1" is described.

Precharge operation of each of the divided bit lines and each of the complementary divided bit lines as well as operation in which the transfer signal T becomes an "L" level are performed in the same manner as when the above described information is "0".

At time t0, the potential on the word line WL1 selected in response to an output from decoder means (not shown) becomes an "H" level. Accordingly, the transistor $Q_S$ in the memory cell MC1 is turned on, so that information stored in the capacitor $C_S$ is read out onto the divided bit line BL2. As a result, the potential on the divided bit line BL2 rises slightly, so a potential difference is developed between the pair of divided bit lines BL2 and $\overline{BL2}$.

At time t1, the sense amplifier activating signal SN2 becomes an "H" level. Accordingly, the sense amplifier driver transistor QN6 is turned on, so the sense amplifier SA2 is activated. As a result, potential difference is increased between the pair of divided bit lines BL2 and $\overline{BL2}$. More specifically, the potential on the divided bit line BL2 is held at a potential a little higher than the intermediate potential, while the complementary divided bit line $\overline{BL2}$ is discharged through the sense amplifier SA2 (through the transistors QN4 and QN6), so the potential thereon becomes near the ground potential $V_{SS}$.

At time t2, the restore circuit activating signal SP2 becomes an "L" level. Accordingly, the restore circuit RE2 is activated through the transistor QP6, so the potential on the divided bit line BL2 is pulled up near the power supply potential $V_{CC}$ through the restore circuit RE2. As a result, the potential difference, between the pair of divided bit lines BL2 and BL2, is increased further.

At time t3, the transfer signal T generated from the transfer signal generator TG becomes an "H" level on being triggered by transition of the restore circuit activating signal SP2 to an "L" level. Accordingly, the transfer gate transistors QT1 and QT2 are turned on, so that the potentials on the divided bit line BL2 and the complementary divided bit line $\overline{BL2}$ are transferred to the divided bit line BL1 and the complementary divided bit line $\overline{BL1}$, respectively. As a result, the potential on the divided bit line BL1 begins to be pulled up through the transfer gate transistor QT1 and the restore circuit RE2, while charge on the complementary divided bit line $\overline{BL1}$ begins to be discharged through the transfer gate QT2 and the sense amplifier SA2.

At time t4, the sense amplifier activating signal SN1 becomes an "H" level. Accordingly, the sense amplifier SA1 is activated through the sense amplifier driver transistor QN5. As a result, the complementary divided bit line $\overline{BL1}$ is discharged at fast speed, so the potential thereon becomes near to the ground potential $V_{SS}$.

At time t5, the restore circuit activating signal SP1 becomes an "L" level. As result, the potential on the divided bit line BL1 is pulled up near to the power supply potential $V_{CC}$ through the restore circuit RE1 which is in an active state.

At time t6, the column selecting signal Y from address decoder means (not shown) becomes an "H" level and the bit line thereof is selected. Accordingly, the column gate transistors QY1 and QY2 are turned on. As a result, the potential on the pair of divided bit lines BL1 and $\overline{BL1}$ are transferred to the data bus line BU and $\overline{BU}$, respectively, so that information "1" stored in the memory cell MC1 is read out.

Fig. 7 is a diagram showing an example of a specific structure of the transfer signal generator shown in Fig. 5. In Fig. 7, an NAND gate comprises p channel MOS transistors QG3 and QG4 and n channel MOS transistors QG1 and QG2. The transistors QG3 and QG4 have gates receiving the restore circuit activating signals SP2 and SP1, respectively, and one conduction terminals connected to each other and the power supply potential $V_{CC}$ and other conduction terminals connected to an output terminal. The n channel MOS transistor QG1 has one conduction terminal connected to the output terminal, a gate receiving the restore circuit activating signal SP2, and another terminal connected to one conduction terminal of the MOS transistor QG2. The n channel MOS transistor QG2 has one conduction terminal connected to the other conduction terminal of the MOS transistor QG1, a gate receiving the restore circuit activating signal SP1, and another terminal connected to the ground potential $V_{SS}$.

A first inverter circuit comprises a p channel MOS transistor QG6 and an n channel MOS transistor QG5 connected in a complementary manner and having gates receiving an output of the NAND gate. The p channel MOS transistor QG6 has one conduction terminal connected to the power supply potential $V_{CC}$, while the n channel MOS transistor QG5 has other conduction terminal connected to the ground potential $V_{SS}$.

A second inverter comprises a p channel MOS transistor QG8 and an n channel MOS transistor QG7 connected in a complementary manner and having gates receiving an output of the first inverter circuit. The p channel MOS transistor OG8 has one conduction terminal connected to the power supply potential $V_{CC}$, while the n channel MOS transistor has another conduction terminal connected to the ground potential $V_{SS}$. The second inverter circuit provides the transfer signal T.

According to the above described circuit structure, if either the restore circuit activating signal SP1 or SP2 becomes an "L" level, the transfer signal T is triggered to be an H" level. More specifically, in, for example, Fig. 6, at the time t2, the restore circuit activating signal SP2 becomes an "L" level. Accordingly, the potential difference on the pair of divided bit lines BL2 and $\overline{BL2}$ is increased and is stabilized. Thereafter, at time t3, the transfer signal becomes an "H" level. Accordingly, the pairs of divided bit lines are connected to each other. As a result, the effect of noise on the bit lines can be removed and noise margin is increased.

Although in the above described embodiment, the sense amplifier comprises an n channel MOS transistor and restore circuit comprises a p channel MOS transistor, they may comprise transistors each having opposite conductivity type if the polarity of the activating signals is suitably selected, in which case the same effect as for the above described embodiment can be obtained.

In addition, although in the above described embodiment,the transfer gate transistor and the column gate transistor each comprise an n channel MOS transistor, they may comprise transistors of different conductivity type if signals applied to the gates are suitably selected, in which case the same effect as for the above described embodiment can be obtained.

Furthermore, although in the above described embodiment,the selecting transistor in each memory cell comprises an n channel MOS transistor, it may comprise a p channel MOS transistor if the potential of the word line is suitably selected, in which case the same effect as for the above described embodiment can be obtained.

Although in the above described embodiment, the transfer signal generator comprises a NAND gate and a two-stage inverter circuit, any circuit structure generating a transfer signal which becomes an active level by being triggered by the first of two restore circuit activating signals to be active may be used, in which case the same effect as for the above described embodiment can be obtained. For example, the transfer signal generator may comprise an inverter circuit comprising a number of stages other than two or only a NAND gate, or other circuit configuration.

Although in the above described embodiment, the pair of bit lines are divided for two blocks, the number of the blocks is not limited to two. The pair of bit lines may be divided for other numbers of blocks, in which case the same effect as for the above described embodiment can be obtained.

Since a sense amplifier and a restore circuit are provided for each pair of divided bit lines, and a transfer gate transistor for connecting the divided bit lines to each other is turned on in response to a signal generated by the first active out of the two restore circuit signals for adjacent restore circuits, the sense operation can be performed in a fast and stable manner, the operation margin of the semiconductor memory can be increased and the gate potential applied to the transfer gate transistor need not be boosted over the power supply potential, the reliability of gate oxide film is not degraded and correspondingly, the reliability of the semiconductor memory is improved overall.

Although the present invention has been described and illustrated in detail, clearly it is to be understood that the same is by way of illustration and example only and is not to be taken by way of any limitation, the scope of the present invention being limited only by the terms of the claims that follow.

## Claims

1. A dynamic random access memory (fig.5) comprising:

   a plurality of paired bit-lines, each each bit-line pair being divided into a plurality of divided bit-line pairs (BL1 & $\overline{BL1}$, BL2 & $\overline{BL2}$,);

   a multiplicity of memory cells (MC1, ...) divided into blocks (CAL1, CAL2) , each block of memory cells being connected to a respective one of the divided bit line pairs (BL1 & $\overline{BL1}$, BL2 & $\overline{BL2}$, ...) and having each side, respectively, a sense amplifier (SA1, SA2, ...) having one or more MOS transistors (QN1 & QN2, QN3 & QN4...) of one conductivity type and a restore circuit (RE1, RE2) having one or more MOS transistors (QP1 & QP2, QP3 & QP4) of the complementary conductivity type; and

   a control circuit for generating restore circuit activating signals (SP1, SP2) for activating sequentially said plurality of restore circuits (RE1, RE2) in a predetermined order (RE2, RE1) commencing with that one (RE2) of the restore circuits (RE1, RE2) included in that one (CAL2) of the blocks (CAL1, CAL2) including that one (MC1) of the memory cells (MC1, ...) that is being addressed, wherein

each respective sense amplifier (SA1, SA2, ...) and each respective restore circuit (RE1, RE2, ...) are connected to the respective divided bit-line pair (BL1 & $\overline{BL1}$, BL2 & $\overline{BL2}$, ...); and

each respective divided bit-line pair (BL1 & $\overline{BL1}$, BL2 & $\overline{BL2}$, ...) is divided from the next (BL2 & $\overline{BL2}$, ...) by one pair of switches (QT1 & QT2), one switch (QT1, QT2) in each bit-line; there being included:

a control means (TG), for controlling operation of said one pair of switches (QT1 & QT2), responsive to that pair of restore circuit activating signals (SP1, SP2) applied respectively to the restore circuits (RE1, RE2) in the blocks (CAL1, CAL2) that are immediately adjacent to said one pair of switches (QT1 & QT2), and operable to render said one pair of switches (QT1 & QT2) conductive to follow and in response to whichever one of said pair of restore circuit activating signals (SP1, SP2) is first to go active.

2. A semiconductor memory, as claimed in claim 1, wherein said control means (TG) comprises a NAND gate (TG1) arranged to receive as inputs thereof the restore circuit activating signals (SP1, SP2) for the two restore circuits (RE1, RE2) included in the two blocks (CAL1, CAL2) immediately adjacent to the corresponding one pair of switches (QT1 & QT2).

3. A semiconductor memory, as claimed in claim 2, wherein said control means (TG) includes inverters (TG2, TG3) connected in series to the output of said NAND gate (TG1)

## Revendications

1. Une mémoire vive dynamique (figure 5) comprenant :

un ensemble de lignes de bits associées par paires, chaque paire de lignes de bit étant divisée en un ensemble de paires de lignes de bit divisées (BL1 & $\overline{BL1}$, BL2 & $\overline{BL2}$);

un ensemble de cellules de mémoire (MC1, ...) divisé en blocs (CAL1, CAL2), chaque bloc de cellules de mémoire étant connecté à l'une respective des paires de lignes de bit divisées (BL1 & $\overline{BL1}$, BL2 & $\overline{BL2}$, ...) et ayant de chaque côté, respectivement un amplificateur de lecture (SA1, SA2, ...) comportant un ou plusieurs transistors MOS (QN1 & QN2, QN3 & QN4 ...) d'un type de conductivité, et un circuit de restauration (RE1, RE2) comportant un ou plusieurs transistors MOS (QP1 & QP2, QP3 & QP4) du type de conductivité complémentaire; et

un circuit de commande destiné à générer des signaux d'activation de circuit de restauration (SP1, SP2) pour activer séquentiellement l'ensemble de circuits de restauration (RE1, RE2) dans un ordre prédéterminé (RE2, RE1), en commençant par celui (RE2) des circuits de restauration (RE1, RE2) qui fait partie de celui (CAL2) des blocs (CAL1, CAL2) qui contient celle (MC1) des cellules de mémoire (MC1, ...) qui est adressée, dans laquelle

chaque amplificateur de lecture respectif (SA1, SA2, ...) et chaque circuit de restauration respectif (RE1, RE2, ...) sont connectés à la paire de lignes de bit divisées respective (BL1 & $\overline{BL1}$, BL2 & $\overline{BL2}$, ...); et

chaque paire de lignes de bit divisées respective (BL1 & $\overline{BL1}$, BL2 & $\overline{BL2}$, ...) est séparée de la suivante (BL2 & $\overline{BL2}$, ...) par une paire d'éléments de commutation (QT1 & QT2), avec un élément de commutation (QT1, QT2) dans chaque ligne de bit; et dans laquelle il existe :

des moyens de commande (TG) destinés à commander le fonctionnement de la paire d'éléments de commutation (QT1 & QT2), sous la dépendance de la paire de signaux d'activation de circuit de restauration (SP1, SP2) qui sont respectivement appliqués aux circuits de restauration (RE1, RE2) dans les blocs (CAL1, CAL2) qui sont immédiatement adjacents à la paire d'éléments de commutation (QT1 & QT2), et qui font passer la paire d'éléments de commutation (QT1 & QT2) à l'état conducteur sous la dépendance de celui des signaux de la paire de signaux d'activation de circuit de restauration (SP1, SP2) qui devient actif en premier, et à la suite du passage de ce signal à l'état actif.

2. Une mémoire à semiconducteurs selon la revendication 1, dans laquelle les moyens de commande (TG) comprennent une porte NON-ET (TG1) qui est connectée de façon à recevoir à titre de signaux d'entrée les signaux d'activation de circuit de restauration (SP1, SP2) pour les deux circuits de restauration (RE1, RE2) qui sont incorporés dans les deux blocs (CAL1, CAL2) immédiatement adjacents à la paire correspondante d'éléments de commutation (QT1 & QT2).

3. Une mémoire à semiconducteurs selon la revendication 2, dans laquelle les moyens de commande (TG) comprennent des inverseurs (TG2, TG3) qui sont connectés en série à la sortie de la porte NON-ET (TG1).

**Ansprüche**

1. Dynamischer Speicher mit wahlfreiem Zugriff (Figur 5) umfassend

eine Vielzahl gepaarter Bitleitungen, wobei jedes Bitleitungspaar in eine Vielzahl geteilter Bitleitungspaare (BL1 & $\overline{BL1}$, BL2 & $\overline{BL2}$) unterteilt ist,

eine Vielzahl von in Blöcke (CAL1, CAL2) unterteilten Speicherzellen (MC1, ...), wobei jeder Block von Speicherzellen mit einem der geteilten Bitleitungspaare (BL1 & $\overline{BL1}$, BL2 & $\overline{BL2}$,...) verbunden ist und an jeder Seite einen Leseverstärker (SA1, SA2,...) mit einem oder mehreren MOS-Transistoren (QN1 & QN2, QN3 & QN4...) eines Leitfähigkeitstypes bzw. einen Rücksetzkreis (RE1, RE2) mit einem oder mehreren MOS-Transistoren (QP1 & QP2, QP3 & QP4) des komplementären Leitfähigkeitstyps umfaßt, und

einen Steuerkreis zur Erzeugung von Rücksetzkreis-Aktivierungssignalen (SP1, SP2) zur sequentiellen Aktivierung der Vielzahl von Rücksetzkreisen (RE1, RE2) in einer vorgegebenen Reihenfolge (RE2, RE1), beginnend mit dem (RE2) Rücksetzkreis (RE1, RE2) in demjenigen (CAL2) Block (CAL1, CAL2), der die gerade adressierte (MC1) Speicherzelle (MC1, ...) umfaßt, wobei

jeder Leserverstärker (SA1, SA2,...) und jeder Rücksetzkreis (RE1, RE2,...) mit dem entsprechenden geteilten Bitleitungspaar (BL1 & $\overline{BL1}$, BL2 & $\overline{BL2}$, ...) verbunden ist, und

jedes Bitleitungspaar (BL1 & $\overline{BL1}$, BL2 & $\overline{BL2}$, ...) vom nächsten (BL2 & $\overline{BL2}$, ...) über ein Paar von Schaltern (QT1 & QT2) getrennt ist und in jeder Bitleitung ein Schalter (QT1, QT2) liegt, und wobei ferner vorgesehen ist

eine Steuereinrichtung (TG) zur Steuerung des Betriebes des einen Schalterpaares (QT1 & QT2) entsprechend dem Paar von Rücksetzkreis-Aktivierungssignalen (SP1, SP2), das den Rücksetzkreisen (RE1, RE2) in den dem beasgten einen Schalterpaar (QT1 & QT2) unmittelbar benachbarten Blöcken (CAL1, CAL2) zugeführt wird, um dieses eine Schalterpaar (QT1 & QT2) in den leitfähigen Zustand zu versetzen und demjenigen Signal des Rücksetzkreis-Aktivierungssignalpaares (SP1, SP2) zu folgen und auf es anzusprechen, das als erstes aktiviert wird.

2. Halbleiterspeicher nach Anspruch 1, wobei die Steuereinrichtung (TG) ein NAND-Glied (TG1) umfaßt, um als Eingänge die Rücksetzkreis-Aktivierungssignale (SP1, SP2) für diejenigen beiden Rücksetzkreise (RE1, RE2) zu empfangen, die in den beiden dem entsprechenden einen Schalterpaar (QT1 & QT2) unmittelbar benachbarten Blöcken (CAL1, CAL2) liegen.

3. Halbleiterspeicher nach Anspruch 2, wobei die Steuereinrichtung (TG) Inverter (TG2, TG3) umfaßt, die in Serie mit dem Ausgang des NAND-Gliedes (TG1) liegen.

# FIG.1

EP 0 239 225 B1

# FIG.2

## FIG.3

EP 0 239 225 B1

EP 0 239 225 B1

# FIG.4

# FIG.5

EP 0 239 225 B1

# FIG.6A

# FIG.6B

WL    Vss

SN1    Vss

SP1    Vss - - -

SN2    Vss

SP2    Vss - - -

T    Vss

BL1 $\overline{BL1}$    Vss - - -

BL2 $\overline{BL2}$    Vss - - -

Y    Vss

BL1

$\overline{BL1}$

BL2

$\overline{BL2}$

$t_0$   $t_1$   $t_2$   $t_3$ $t_4$   $t_5$   $t_6$

# FIG.7

EP 0 239 225 B1